# EUROPEAN PATENT APPLICATION

(11) **EP 4 117 012 A1**
(43) Date of publication of application: **11.01.2023**
(21) Application number: 21184294.3
(22) Date of filing: 07.07.2021
(51) Int. Cl.: H01J 37/02

(54) **CHARGED PARTICLE-OPTICAL DEVICE, CHARGED PARTICLE APPARATUS AND METHOD**

(71) Applicant: ASML Netherlands B.V., 5500 AH Veldhoven (NL)
(72) Inventor: SLOT, Erwin, 5500 AH Veldhoven (NL)
(74) Representative: ASML Netherlands B.V.

(57) **Abstract**

A method for projecting a charged particle multi-beam toward a sample comprises: manipulating respective sub-beams of a charged particle multi-beam using a control lens array comprising a plurality of control lenses for the respective sub-beams; controlling the control lens array to manipulate the sub-beams such that the sub-beams are shaped by respective apertures of a beam shaping aperture array such that less than a threshold current of charged particles of each sub-beam passes through the respective apertures of the beam shaping aperture array, down-beam of the control lens array, comprising a plurality of apertures for the respective sub-beams; and controlling the control lens array to manipulate the sub-beams such that at least the threshold current of at least a proportion of the sub-beams passes through the respective apertures of the beam shaping aperture array.

## Description

### FIELD

The embodiments provided herein generally relate charged particle-optical devices, charged particle apparatuses and methods for projecting a charged particle multi-beam toward a sample.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

When the primary electron beam scans the sample, charges may be accumulated on the sample due to large beam current, which may affect the quality of the image. The material structure may be illuminated with light and/or flooded with electrons in order to improve the defect contrast during defect inspection. For example, to regulate the accumulated charges on the sample, an Advanced Charge Controller (ACC) module may be employed to illuminate a light beam, such as a laser beam, on the sample, so as to control the accumulated charges due to effects such as photoconductivity, photoelectric, or thermal effects. It can be difficult to illuminate the light beam on the sample. For example, the dimensions of the pattern inspection tool may make it difficult to reach the sample with the light beam.

Additionally or alternatively, a flooding column may be provided for flooding the sample with electrons. The flooding column is separate from the SEM inspection column that focuses the beam of electrons onto the sample for inspection. Switching between the flooding column and the SEM inspection column can require movement of the sample so that the same part of the sample undergoes both processes. The movement can be a significant contributor to the overall time taken to perform the inspection.

### SUMMARY

It is an object of the present disclosure to provide embodiments that support increasing throughput for inspections involving improved image contrast to aid defect inspection.

According to a first aspect of the invention, there is provided a charged particle-optical device for a charged particle apparatus configured to project a charged particle multi-beam toward a sample, the charged particle-optical device comprising: a control lens array comprising a plurality of control lenses configured to adjust an charged particle-optical parameter of respective sub-beams of a charged particle multi-beam for focusing by respective down-beam objective lenses; a beam shaping aperture array, down-beam of the control lens array, comprising a plurality of apertures for the respective sub-beams; and a controller configured to control the control lens array so that the control lenses selectively (a) manipulate the respective sub-beams such that the respective sub-beams are shaped by the respective apertures of the beam shaping aperture array such that less than a threshold current of charged particles of each sub-beam passes through the respective apertures of the beam shaping aperture array, and (b) manipulate the respective sub-beams such that at least the threshold current of at least a proportion of the sub-beams passes through the respective apertures of the beam shaping aperture array.

According to a second aspect of the invention, there is provided a method for projecting a charged particle multi-beam toward a sample, the method comprising: manipulating respective sub-beams of a charged particle multi-beam using a control lens array comprising a plurality of control lenses for the respective sub-beams; controlling the control lens array to manipulate the sub-beams such that the sub-beams are shaped by respective apertures of a beam shaping aperture array such that less than a threshold current of charged particles of each sub-beam passes through the respective apertures of the beam shaping aperture array, down-beam of the control lens array, comprising a plurality of apertures for the respective sub-beams; and controlling the control lens array to manipulate the sub-beams such that at least the threshold current of at least a proportion of the sub-beams passes through the respective apertures of the beam shaping aperture array.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam charged particle apparatus that is part of the exemplary charged particle beam inspection apparatus of **FIG. 1****.**
**FIG. 3** is a schematic diagram of an exemplary charged particle apparatus comprising a macro collimator and macro scan deflector.
**FIG. 4** is a schematic diagram of an exemplary multi-beam charged particle apparatus according to an embodiment.
**FIG. 5** is a schematic diagram of part of the multi-beam charged particle apparatus of **FIG. 4****.**
**FIG. 6** s a schematic diagram of an exemplary multi-beam charged particle apparatus according to an embodiment.
**FIG. 7** is a schematic cross-sectional view of an objective lens array of an charged particle apparatus according to an embodiment.
**FIG. 8** is a bottom view of a modification of the objective lens array of **FIG. 7****.**
**FIG. 9** is an enlarged schematic cross-sectional view of a detector incorporated in the objective lens array of **FIG. 7****.**
**FIG. 10** is a bottom view of a detector element of a detector.
**FIG. 11** is a schematic diagram of the exemplary charged particle apparatus of **FIG. 3** flooding the sample.
**FIG. 12** is a schematic cross-sectional view of a control lens array and an objective lens array of a charged particle-optical device according to an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the charged particle-optical system or apparatus. The primary charged particles interact with the sample and generate secondary charged particles. The detection apparatus captures the secondary charged particles from the sample as the sample is scanned so that the SEM can create an image of the scanned area of the sample. For high throughput inspection, some of the inspection apparatuses use multiple focused beams, i.e. a multi-beam, of primary charged particles. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system (or electron-optical device), it is appreciated that the embodiments are not used to limit the present disclosure to specific charged particles. References to electrons throughout the present document may therefore be more generally considered to be references to charged particles, with the charged particles not necessarily being electrons. For example, reference to an electron apparatus may be more generally considered to be reference to a charged particle apparatus.

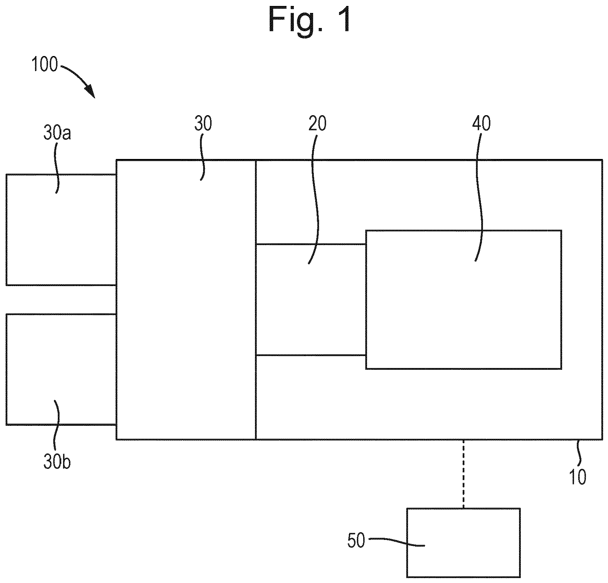

Reference is now made to FIG. 1, which is a schematic diagram illustrating an exemplary electron beam inspection apparatus 100. The electron beam inspection apparatus 100 of FIG. 1 includes a main chamber 10, a load lock chamber 20, an electron apparatus 40 (which may also be called an electron assessment apparatus or an electron beam system or tool), an equipment front end module (EFEM) 30 and a controller 50. The electron apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron apparatus 40 by which it may be inspected. The electron apparatus 40 comprises an electron-optical device 41. The electron-optical device 41 may be an electron-optical column configured to project at least one electron beam towards the sample 208, or an objective lens module configured to focus at least one electron beam onto the sample 208. The electron-optical device 41 may also comprise a detector module configured to detect electrons emitted from the sample 208, and/or a control lens module configured to adjust an electron-optical parameter of at least one electron beam. In an embodiment the electron-optical column may comprise the objective lens module and the detector module and optionally the control lens module. In an embodiment the electron-optical device 41 comprises an objective lens assembly which may be comprised in the electron-optical column. The objective lens assembly comprises an objective lens array associated with (e.g. integrated with) one or more other electron-optical components such as a detector array and optionally a control lens array. The electron-optical device 41 may be a multi-beam electron-optical device 41 for a multi-beam projected towards the sample 208. In an embodiment the electron-optical device 41 comprises multi-column comprising a plurality of electron-optical columns configured to project respective electron beam or electron multi-beams towards the sample 208.

The controller 50 is electronically connected to electron-optical components of the electron-optical device 41 of the electron apparatus 40. The controller 50 may be a processor (such as a computer) configured to control the electron beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the electron beam inspection apparatus 100 or it can be distributed over at least two of the component elements. The controller may be considered to be part of the electron-optical device 41. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

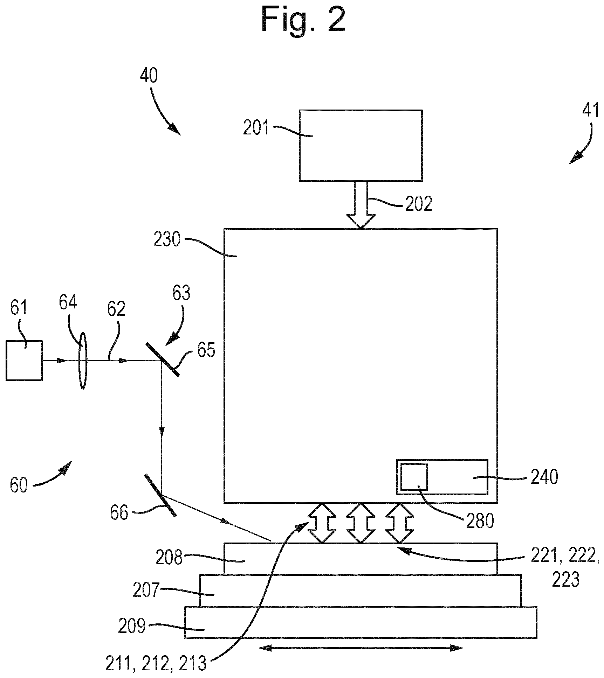

Reference is now made to **FIG. 2****,** which is a schematic diagram illustrating an exemplary electron apparatus 40 including a multi-beam electron-optical device 41 that is part of the exemplary electron beam inspection apparatus 100 of **FIG. 1****.** The multi-beam electron-optical device 41 comprises an electron source 201 and a projection apparatus 230. The electron apparatus 40 further comprises a motorized stage 209 and a sample holder 207. The projection apparatus 230 may be referred to as the electron-optical device 41. The sample holder 207 is supported by motorized stage 209 so as to hold a sample 208 (e.g., a substrate or a mask) for inspection. The multi-beam electron-optical device 41 may further comprise a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the electron beam inspection apparatus 100 of **FIG. 1****,** such as the electron source 201, the detector 240, the projection apparatus 230, and the motorized stage 209. The controller 50 may perform various image and signal processing functions. The controller 50 may also generate various control signals to govern operations of the electron beam inspection apparatus 100, including the multi-beam electron apparatus 40.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy ≤ 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam electron apparatus 40 such as the detector 240 (as shown in **FIG. 2****).** However, the signal processing system 280 may be incorporated into any components of the electron beam inspection apparatus 100 or multi-beam electron apparatus 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

Known multi-beam systems, such as the electron apparatus 40 and electron beam inspection apparatus 100 described above, are disclosed in US2020118784, US20200203116, US 2019/0259570 and US2019/0259564 which are hereby incorporated by reference.

As shown in **FIG. 2****,** in an embodiment the electron apparatus 40 comprises a projection assembly 60. The projection assembly 60 may be a module and may be referred to as an ACC module. The projection assembly 60 is arranged to direct a light beam 62 such that the light beam 62 enters between the electron-optical device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

In an embodiment the projection system 60 comprises a light source 61. The light source 61 is configured to emit the light beam 62. In an embodiment the light source 61 is a laser light source. Laser light provides a coherent light beam 62. However, other types of light source can alternatively be used. In an embodiment the light source 61 is configured to emit a light beam 62 having a wavelength in the range of from 450nm to 850nm.

In an embodiment the projection assembly 60 comprises an optical system 63. In an embodiment the optical system 63 is configured to focus the light beam 62 to be narrower in a direction perpendicular to the surface of the sample 208 than in a direction parallel to the surface. In an embodiment the optical system 63 comprises a cylindrical lens 64. The cylindrical lens 64 is configured to focus the light beam 62 more in one direction than in an orthogonal direction. The cylindrical lens increases the design freedom for the light source 61. In an embodiment the light source 61 is configured to emit a light beam 62 having a circular cross section. The cylindrical lens 64 is configured to focus the light beam 62 such that the light beam has an elliptical cross section. In an embodiment the optical system 63 comprises reflecting surfaces 65, 66 such as mirrors. For example two reflecting surfaces 65, 66 may be provided.

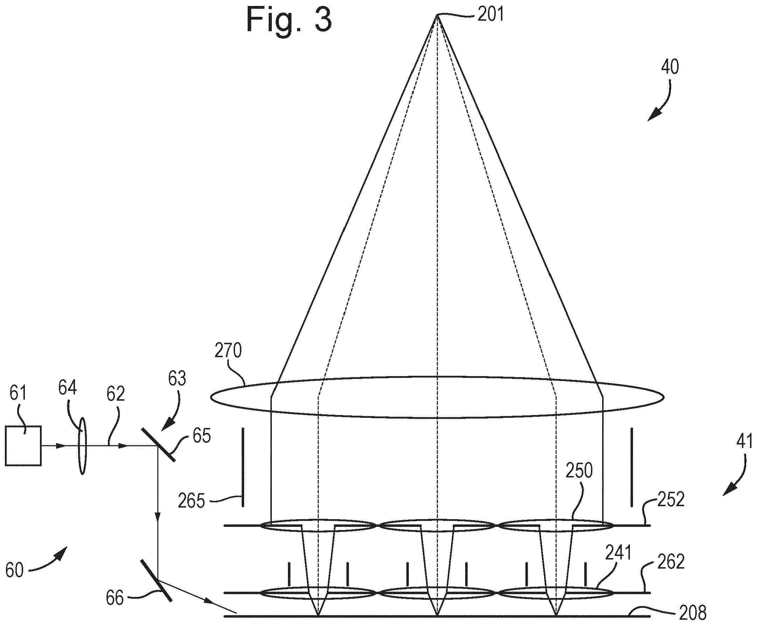

Components of an electron apparatus 40 which may be used in the present invention are described below in relation to **FIG. 3** which is a schematic diagram of an electron apparatus 40. The electron apparatus 40 of **FIG. 3** may correspond to the electron apparatus 40 (which may also be referred to as a system or a tool) mentioned above.

As shown in **FIG. 3****,** In an embodiment the electron apparatus 40 comprises an electron source 201, a macro collimator 270, a macro scan deflector 265, sub-beam forming array 252, a control lens array 250, an objective lens array 241 and a beam shaping aperture array or beam shaping array 262.

As shown in **FIG. 3****,** In an embodiment the electron apparatus 40 comprises an electron source 201. The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam. The electron source 201 is desirably a high brightness thermal field emitter with a good compromise between brightness and total emission current.

As shown in **FIG. 3****,** In an embodiment the electron apparatus 40 comprises a macro collimator 270. The macro collimator 270 may be part of the electron-optical device 41. Alternatively, the macro collimator 270 may be separate from the electron-optical device 41. The electron source 201 directs electrons toward a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). Thus the path of each of sub-beam is at least intended to be orthogonal to the surface of the sample 208. The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro collimator 270 may be partially or wholly replaced by a collimator element array provided down-beam of the sub-beam forming array. Each collimator element collimates a respective sub-beam. The collimator element array may be formed using MEMS manufacturing techniques so as to be spatially compact. The collimator element array may be the first deflecting or focusing electron-optical array element in the beam path down-beam of the source 201. The collimator element array may be up beam of the control lens array 250. The collimator element array may be in the same module as the control lens array 250.

As shown in **FIG. 3****,** In an embodiment the electron apparatus 40 comprises a sub-beam forming array 252. The sub-beam forming array 252 may be part of the electron-optical device 41. Alternatively, the sub-beam forming array 252 may be separate from the electron-optical device 41. The sub-beam forming array 252 is configured to form sub-beams from the primary electron beam. Sub-beams may be derived from the beam, for example, using a sub-beam forming array 252 (also known as a beam limiting aperture array) defining an array of beam-limiting apertures. The beam may separate into the sub-beams on meeting the control lens array 250, described below. The sub-beams are substantially parallel on entry to the control lens array 250.

As shown in **FIG. 3****,** in an embodiment the electron-optical device 41 comprises an objective lens array 241. The objective lens array 241 comprises a plurality of objective lenses. The objective lens array 241 may be an exchangeable module. The exchangeable module may feature other electron-optical elements such as a detector array and/or a control lens array

Below (i.e. down beam or further from the electron source 201) the macro collimator 270 there is a control lens array 250. The control lenses in the control lens array 250 are configured to apply a focusing action to the sub-beams prior to the sub-beams reaching the objective lens array 241. The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. Additionally or alternatively, the control lenses in the control lens array 250 are configured to control the opening angle of the sub-beams and/or to control demagnification (i.e. magnification) of the sub-beams and/or to control landing energy.

It is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least one electrode, preferably at least two electrodes (e.g. two or three electrodes) connected to respective potential sources. The control lens array 250 may comprise one or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned up-beam of the objective lens array 241.

The control lens array 250 may be considered as one or more electrodes additional to the electrodes of the objective lens array 241. The control lens array 250 provides extra degrees of freedom for controlling the sub-beams. A greater number of electrodes comprised in the control lens array 250 provides a greater number of degrees of freedom. For example, these extra electrodes may permit landing energy and/or magnification control independent of the field strength of the objective lens array 241. In some designs the control lens may thus be part of the objective lens. Reference to such electrodes may thus be as part of the objective lens rather than a separate lens such as a control lens. Reference to a control lens in such an arrangement is reference to functionally equivalent electrodes of the objective lens

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the electron-optical device 41. The control lens array 250 is optional, but is preferred for optimizing a sub-beam up-beam of the objective lens array 241.

For ease of illustration, lens arrays are depicted schematically herein by arrays of oval shapes (as shown in **FIG. 3****).** Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

In the embodiment of **FIG. 3** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan deflector array comprises a plurality of scan deflectors. The scan deflector array may be formed using MEMS manufacturing techniques. Each scan deflector scans a respective sub-beam over the sample 208. The scan-deflector array may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array together, preferably in synchronization.

In some embodiments, the electron-optical device 41 further comprises a sub-beam forming array 252. The sub-beam forming array 252 defines an array of beam-limiting apertures. The sub-beam forming array 252 may be referred to as an upper beam-limiting aperture array or up-beam beam-limiting aperture array. The sub-beam forming array 252 may comprise a plate (which may be a plate-like body) having a plurality of apertures. The sub-beam forming array 252 forms sub-beams from a beam of electrons emitted by the source 201. Portions of the beam other than those contributing to forming the sub-beams may be blocked (e.g. absorbed) by the sub-beam forming array 252 so as not to interfere with the sub-beams down-beam. The sub-beam forming array 252 may be referred to as a sub-beam defining aperture array or an upper beam limiter. The apertures of the sub-beam forming array 252 may have a diameter of at least 20 µm, optionally at least 50 µm, optionally at least 100 µm, and optionally 120 µm. The apertures have a pitch that may by equal to that of the apertures of the beam apertures 406.

In some embodiments, as exemplified in **FIG. 3****,** the electron-optical device 41 is an objective lens array assembly (which is a unit that comprises the objective lens array 241) and comprises a beam shaping aperture array or beam shaping array 262. The beam shaping array 262 defines an array of beam-limiting apertures. The beam shaping array 262 may be referred to as a lower beam limiter, lower beam-limiting aperture array or final beam-limiting aperture array. The beam shaping array 262 may comprise a plate (which may be a plate-like body) having a plurality of apertures. The beam shaping array 262 may be down-beam from at least one electrode (optionally from all electrodes) of the control lens array 250. In some embodiments, the beam shaping array 262 is down-beam from at least one electrode (optionally from all electrodes) of the objective lens array 241.

In an arrangement, the beam shaping array 262 is structurally integrated with an electrode of the objective lens array 241. Desirably, the beam shaping array 262 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping array 262 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

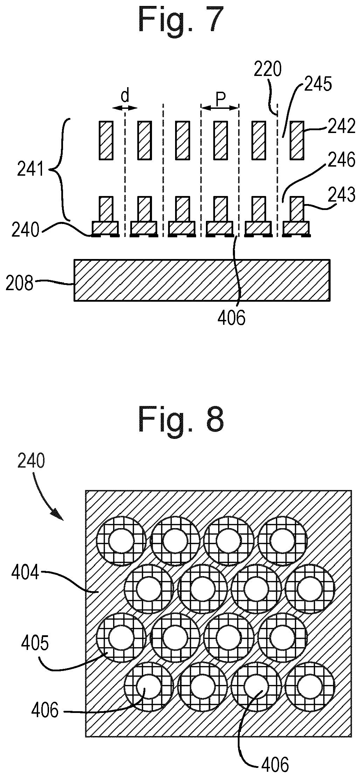

Any of the electron-optical devices 41 described herein may further comprise a detector 240. The detector 240 detects electrons emitted from the sample 208. The detected electrons may include any of the electrons detected by an SEM, including secondary and/or backscattered electrons emitted from the sample 208. An exemplary construction of a detector 240 is shown in **FIG. 7** and described in more detail below with reference to **FIGs. 8-10****.**

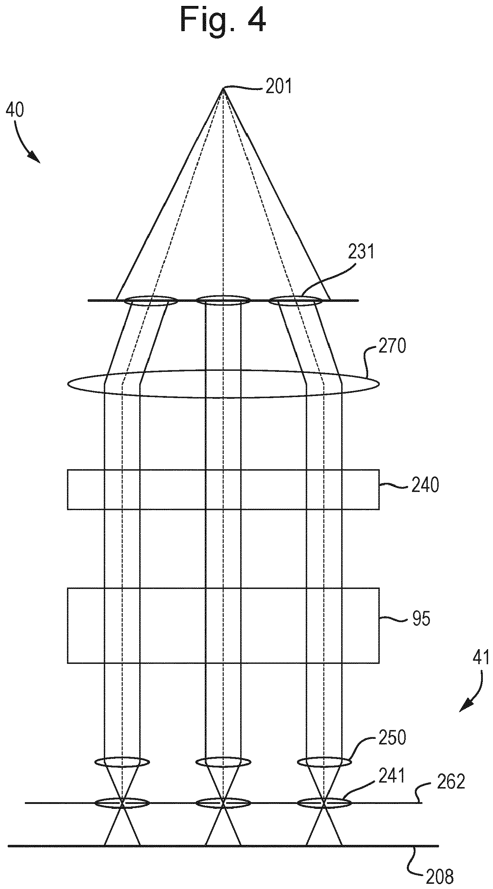

**FIG. 4** schematically depicts an electron apparatus 40 according to an embodiment. Features that are the same as those described above are given the same reference numerals. For conciseness, such features are not described in detail with reference to **FIG. 4****.** For example, the source 201, the macro collimator 270, the objective lens array 241 and the sample 208 may be as described above.

In an embodiment the electron apparatus 40 comprises an array condenser lenses 231. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which electrons have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

As described above, in an embodiment the detector 240 is between the objective lens array 241 and the sample 208. The detector 240 may face the sample 208. Alternatively, as shown in **FIG. 4****,** in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter so that deflector array may be referred to as a beam separator. The deflector array 95 is configured to provide a magnetic field to disentangle the electrons projected to the sample 208 from the secondary electrons from the sample 208.

In an embodiment the detector 240 is configured to detect signal particles by reference to the energy of the electron, i.e. dependent on a band gap. Such a detector 240 may be called an indirect current detector. The secondary electrons emitted from the sample 208 gain energy from the fields between the electrodes. The secondary electrodes have sufficient energy once they reach the detector 240.

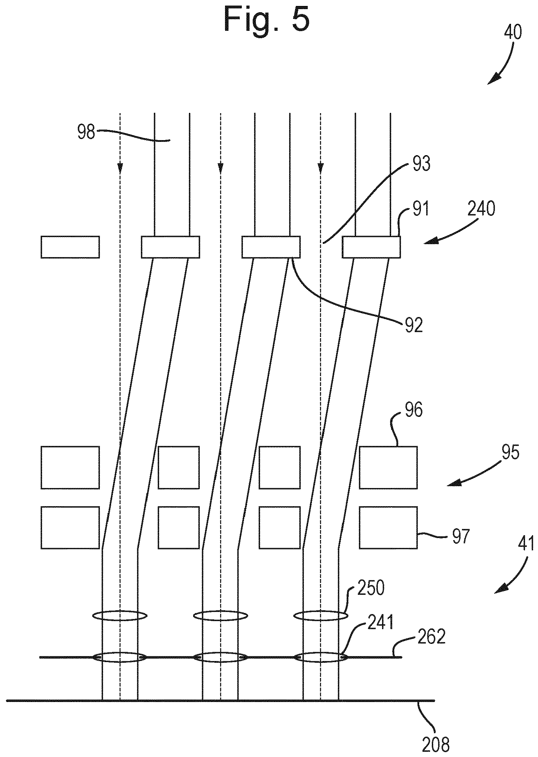

**FIG. 5** is a close-up view of part of the electron apparatus 40 shown in **FIG. 4****.** In an embodiment the detector 240 comprises an electron to photon converter array 91. The electron to photon converter array 91 comprises a plurality of fluorescent strips 92. Each fluorescent strip 92 is located in the plane of the electron to photon converter array 91. At least one fluorescent strip 92 is arranged between two adjacent electron beams projected towards the sample 208.

In an embodiment, the fluorescent strips 92 extend substantially in the horizontal direction. Alternatively, the electron to photon converter array 91 may comprise a plate of a fluorescent material with openings 93 for the projected electron beams.

The projected electron beams, indicated by dashed lines in **FIG. 5****,** are projected through the plane of the electron to photon converter array 91, via the openings 93 between the fluorescent strips 92, towards the deflector array 95.

In an embodiment the deflector array 95 comprises a magnetic deflector 96 and an electrostatic deflector 97. The electrostatic deflector 97 is configured to counteract the deflection of the magnetic deflector 96 for the projected electron beams transmitted towards the sample 208. Accordingly, the projected electron beams may be shifted to a small extent in the horizontal plane. The beams down-beam of the deflector array 95 are substantially parallel to the beams up-beam of the deflector array 95.

In an embodiment the objective lens array 241 comprises a plurality of plates for guiding secondary electrons created in the sample 208 towards the deflector array 95. For the secondary electrons, which travel in opposite direction with respect to the projected electron beams, the electrostatic deflector 97 does not counteract the deflection of the magnetic deflector 96. Instead, the deflections of the secondary electrons by the electrostatic deflector 97 and the magnetic deflector 96 add up. Accordingly, the secondary electrons are deflected to travel at an angle with respect to the optical axis in order to transmit the secondary electrons onto the fluorescent strips 92 of the detector 240.

At the fluorescent strips 92, photons are created upon incidence of the secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

In an embodiment the array of condenser lenses 231 and the macro collimator 270 are arranged such that the pitch between the sub-beams is at least 500 µm and optionally at least 1 mm. The pitch between the sub-beams is great enough to accommodate the Wien filters per beam or beam row and the optical fibers 98. In an embodiment the condenser lenses of the array of condenser lenses 231 have a diameter of at least 100 µm, optionally at least 200 µm, and optionally at least 500 µm.

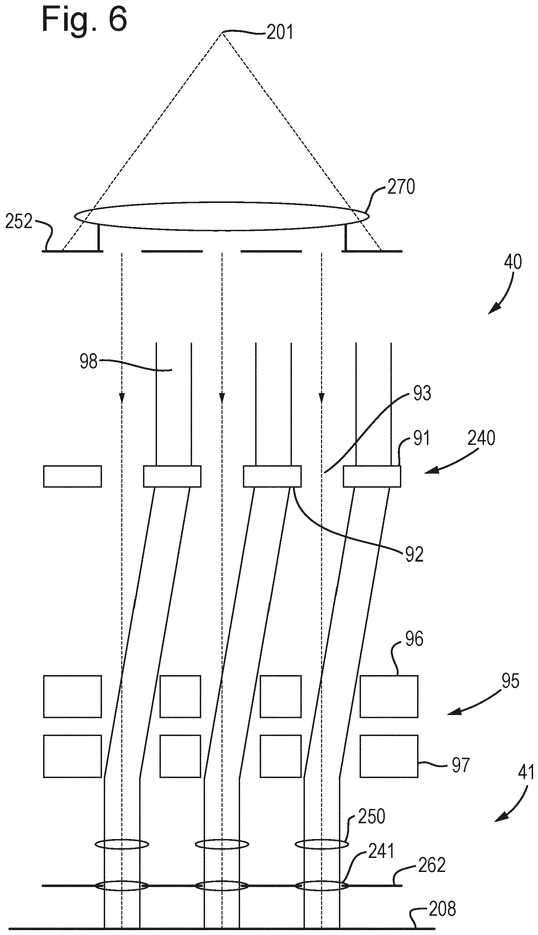

**FIG. 6** is a schematic diagram of an exemplary multi-beam electron apparatus 40 according to an embodiment. In an embodiment the electron apparatus 40 comprises an electron source 201, a macro collimator 270, a sub-beam forming array 252, a detector 240, a deflector array 95, a control lens array 250, an objective lens array 241 and a beam shaping array 262.

The electron source 201 and the macro collimator 270 may function and have features as described above with reference to **FIG. 3****,** for example. Features of the electron apparatus 40 that are the same as described above with reference to **FIG. 3** are not repeated here to avoid redundancy of description. In an alternative arrangement the functions and positions of the collimator and the sub-beam forming array 252 can be different. The sub-beam forming array 252 may form part of or be associated with an electrostatic condenser lens such a macro-condenser lens or a condenser lens array. The sub-beam forming array may be a most down-beam element of the macro-collimator or adjacently down-beam of the most down-beam electrode of an electrostatic macro-. Such a condenser lens may have two or more electrodes of for example parallel plates. Alternatively the sub-beam forming array may be up-beam of or form an up-beam element of a condenser lens array. In an arrangement, the beam forming array splits the beam from the source into a plurality of sub-beams. Thus each lens in a condenser lens array may correspond to an associated sub-beam. In an embodiment of such an arrangement, collimator may be down-beam of the beam-forming array for example at a plane of intermediate foci of the condenser lenses. The collimator may be a macro-collimator or a collimator array which may be an array of deflectors. The collimator functions as described in earlier described arrangement. That is, directing the sub-beams down beam of the collimator such that their trajectory is substantially parallel to each other and preferably orthogonal to the surface of the sample.

The sub-beam forming array 252 may function and have features as described above with reference to **FIG. 3****,** for example. However, in an embodiment the sub-beam forming array 252 is arranged such that the pitch between the sub-beams is at least 500 µm and optionally at least 1 mm. The pitch between the sub-beams is great enough to accommodate the Wien filters per beam or beam row and the optical fibers 98. In an embodiment the apertures of the sub-beam forming array 252 have a diameter of at least 100 µm, optionally at least 200 µm, and optionally at least 500 µm.

The detector 240, the deflector array 95, the control lens array 250, the objective lens array 241 and the beam shaping array 262 may function and have features as described above with reference to **FIG. 4** and **FIG. 5****,** for example. Features of the electron apparatus 40 that are the same as described above with reference to **FIG. 4** and **FIG. 5** are not repeated here to avoid redundancy of description.

The beam shaping array 262 is associated with the objective lens array 241. The control lens array 250 is located up-beam of the beam shaping array 262. The control lens array 250 is configured to focus the sub-beams through the respective apertures of the beam shaping array 262. The sub-beam forming array 252 is located up-beam of the detector 240. The sub-beam forming array 252 helps to reduce illumination of the optical fibers 98 by the electron beams.

The objective lens array 241 of any embodiment may comprise at least two electrodes in which are defined aperture arrays. In other words, the objective lens array comprises at least two electrodes with a plurality of holes or apertures. **FIG. 7** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The objective lens array 241 may comprise two electrodes, as shown in **FIG. 7****,** or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than the objective lens.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to de-magnify the electron beam by a factor greater than 10, desirably in the range of 50 to 100 or more.

A detector 240 is provided to detect secondary and/or backscattered electrons emitted from the sample 208. The detector 240 is positioned between the objective lenses 234 and the sample 208. The detector 240 may otherwise be referred to as a detector array or a sensor array, and the terms "detector" and "sensor" are used interchangeably throughout the application.

In an embodiment the electron-optical device 41 is configured to project a beam of electrons towards the sample 208. The electron-optical device 41 may comprise the objective lens array 241. The electron-optical device 41 may comprise the detector 240. The array of objective lenses (i.e. the objective lens array 241) may correspond with the array of detectors (i.e. the detector 240) and/or any of the beams (i.e. the sub-beams).

An exemplary detector 240 is described below. However, any reference to the detector 240 could be a single detector (i.e. at least one detector) or multiple detectors as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIGs. 8-10****.**

The detector 240 may be positioned between the objective lens array 241 and the sample 208. The detector 240 is configured to be proximate the sample 208. The detector 240 may be very close to the sample 208. Alternatively, there may be a larger gap between, the detector 240 and the sample 208. The detector 240 may be positioned in the device so as to face the sample 208. Alternatively, the detector 240 may be positioned elsewhere in the electron-optical device 41 such that part of the electron-optical device that faces the sample 208 is other than, and thus is not, a detector. For example the detector 240 may have a part at least associated with an electrode of the objective lens array 241.

For a multi-beam system of the type shown in **FIGs. 2-4****,** preferably, a distance between the electron-optical column and the sample 208 is less than or equal to approximately 50 µm. The distance is determined as the distance from a surface of the sample 208 facing the electron-optical column and a surface of the electron-optical column facing the sample 208.

**FIG. 8** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 8****,** the beam apertures 406 are in a hexagonal close packed array. The beam apertures 406 can also be differently arranged, e.g. in a rectangular array. The beam arrangement of the hexagonal arrangement in **FIG. 8** may be more densely packed than a square beam arrangement. The detector elements 405 may be arranged in a rectangular array or a hexagonal array.

In an embodiment the beam apertures 406 have a pitch P of at least 50 µm, optionally at least 100 µm, optionally at least 200 µm and optionally 210 µm. A greater pitch allows for the diameter d of the beam apertures 406 to be greater. In an embodiment the beam apertures 406 have a pitch P of at most 1000 µm, optionally at most 500 µm, and optionally at most 250 µm. The pitch of the beam apertures 406 defines the pitch of the sub-beams of the electron multi-beam that is projected toward the sample 208. In an embodiment the sub-beams of the electron multi-beam have a pitch of at least 50 µm, optionally at least 100 µm, optionally at least 200 µm and optionally 210 µm. In an embodiment the beam apertures 406 have a diameter d that is less than the pitch P. In an embodiment the beam apertures 406 have a diameter d that is at least 10 µm, and optionally at least 20 µm. In an embodiment the beam apertures 406 have a diameter d that is at most 100 µm, optionally at most 50 µm, and optionally at most 30 µm. A smaller diameter d improves the resolution such that smaller defects can be detected.

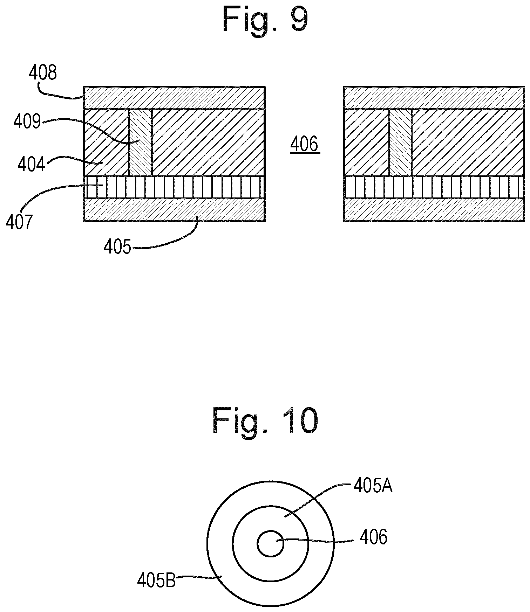

**FIG. 9** depicts at a larger scale a part of the detector 240 in cross section. The detector elements 405 form the bottommost, i.e. most close to the sample 208, surface of the detector 240. Between the detector elements 405 and the main body of the substrate 404 a logic layer 407 may be provided. At least part of the signal processing system may be incorporated into the logic layer 407.

A wiring layer 408 is provided on the backside of, or within, the substrate 404 and connected to the logic layer 407 by through-substrate vias 409. The number of through-substrate vias 409 need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector 240.

The integrated detector array described above is particularly advantageous when used with a tool having tunable landing energy as secondary electron capture can be optimized for a range of landing energies.

The detector 240 may be implemented by integrating a CMOS chip detector into a bottom electrode of the objective lens array 241. Integration of a detector 240 into the objective lens array 241 or other component of the electron-optical device 41 allows for the detection of electrons emitted in relation to multiple respective sub-beams. The CMOS chip is preferably orientated to face the sample (because of the small distance (e.g. 50 µm or less) between the sample and a bottom of the electron-optical column). In an embodiment, detector elements 405 to capture the secondary electrons are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E-fields.

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241). Therefore, the diameter of each detector element may be less than approximately 600 µm, and preferably between approximately 50 µm and 500 µm. As described above, the pitch may be selected depending on the intended distance between the sample 208 and the detector 240. In an embodiment the outer shape of the detector element 405 is a circle, but this can be made a square to maximize the detection area. Also the diameter of the through-substrate via 409 can be minimized. A typical size of the electron beam is in the order of 5 to 15 micron.

In an embodiment, a single detector element 405 surrounds each beam aperture 406. In another embodiment, a plurality of detector elements 405 are provided around each beam aperture 406. The electrons captured by the detector elements 405 surrounding one beam aperture 406 may be combined into a single signal or used to generate independent signals. The detector elements 405 may be divided radially. The detector elements 405 may form a plurality of concentric annuluses or rings. The detector elements 405 may be divided angularly. The detector elements 405 may form a plurality of sector-like pieces or segments. The segments may be of similar angular size and/or similar area. The electrode elements may be separated both radially and angularly or in any other convenient manner.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance.

A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

The electron current collected by detector element 405 is amplified, for example by an amplifier such as a TIA.

In an embodiment, the objective lens array 241 is an exchangeable module, either on its own or in combination with other elements such as the control lens array 250 and/or the detector 240 and/or the beam shaping array 262 and/or the sub-beam forming array 252. The exchangeable module may be field replaceable, i.e. the module can be swapped for a new module by a field engineer. In an embodiment, multiple exchangeable modules are contained within the tool and can be swapped between operable and non-operable positions without opening the electron apparatus 40.

In an embodiment the exchangeable module comprises an electron-optical component, and specifically may be the electron-optical device, which is on a stage permitting actuation for positioning of the component. In an embodiment the exchangeable module comprises a stage. In an arrangement the stage and the exchangeable module may be an integral part of the tool 40. In an arrangement the exchangeable module is limited to the stage and the device, such as the electron-optical device, it supports. In an arrangement the stage is removable. In an alternative design the exchangeable module comprising the stage is removable. The part of the electron apparatus 40 for the exchangeable module is isolatable, that is the part of the electron apparatus 40 is defined by a valve up-beam and a valve down-beam of the exchangeable module. The valves can be operated to isolate the environment between the valves from the vacuum up-beam and down-beam of the valves respectively enabling the exchangeable module to be removed from the electron apparatus 40 whilst maintaining the vacuum up-beam and down-beam of the part of the electron apparatus 40 associated with the exchangeable module. In an embodiment the exchangeable module comprises a stage. The stage is configured to support a device, such as the electron-optical device, relative to the beam path. In an embodiment the module comprises one or more actuators. The actuators are associated with the stage. The actuators are configured to move the device relative to the beam path. Such actuation may be used to align the device and the beam path with respect to each other.

In an embodiment, the exchangeable module is a microelectromechanical systems (MEMS) module. MEMS are miniaturized mechanical and electromechanical elements that are made using microfabrication techniques. In an embodiment, the exchangeable module is configured to be replaceable within the electron apparatus 40. In an embodiment, the exchangeable module is configured to be field replaceable. Field replaceable is intended to mean that the module may be removed and replaced with the same or different module while maintaining the vacuum in which the electron-optical tool 40 is located. Only a section of the electron apparatus 40 is vented corresponding to the module is vented for the module to be removed and returned or replaced.

The control lens array 250 may be in the same module as an objective lens array 241, i.e. forming an objective lens array assembly or objective lens arrangement, or it may be in a separate module

In some embodiments, one or more aberration correctors are provided that reduce one or more aberrations in the sub-beams. The one or more aberration correctors may be provided in any of the embodiments, e.g. as part of the electron-optical device, and/or as part of an optical lens array assembly, and/or as part of an assessment system. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up-beam or down-beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the sub-beams 211, 212, 213 over the sample 208. In an embodiment, the scanning deflectors described in US 2010/0276606, which document is hereby incorporated by reference in its entirety, may be used.

The detector may be provided with multiple portions and more specifically, multiple detecting portions . The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406 as shown in **FIG 9****,** which provides an example of such a detector.

As shown in **FIG. 10****,** the detector element 405, in which an aperture 406 is defined and configured for the through passage of an electron beam, comprises an inner detecting portion 405A and an outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings.

The invention can be applied to various different tool architectures. For example, the electron apparatus 40 may comprise a plurality of electron-optical columns of multi-beams. The electron-optical columns may comprise the electron-optical device 41 described in any of the above embodiments or aspects. As a plurality of electron-optical columns (or a multi-column tool), the devices may be arranged in an array which may number two to one hundred electron-optical columns or more. The electron apparatus 40 may take the form of an embodiment as described with respect to and depicted in **FIG. 3** or as described with respect to and depicted in **FIG. 4****.** An electron-optical column may optionally comprise a source.

As mentioned above, to increase contrast for electron beam inspection charge can be deposited on the surface of the sample 208 prior to the inspection of the sample 208. This process is called flooding. For inspection based on a voltage contrast, high density flooding is required. Low density flooding may be used for an assessment mode for example in metrology or inspection applications.

As shown in **FIG. 3****,** in an embodiment, the electron-optical device 41 is for an electron apparatus 40 configured to project an electron multi-beam toward the sample 208. The electron-optical device 41 may be an electron-optical column configured to project at least one electron beam towards the sample 208, or an objective lens module configured to focus at least one electron beam onto the sample 208. The electron-optical device 41 may also comprise a detector module configured to detect electrons emitted from the sample 208, and/or a control lens module configured to adjust an electron-optical parameter of at least one electron beam. In an embodiment the electron-optical column may comprise the objective lens module and the detector module and optionally the control lens module. In an embodiment the electron-optical device 41 comprises an objective lens assembly which may be comprised in the electron-optical column. The objective lens assembly comprises an objective lens array associated with (e.g. integrated with) one or more other electron-optical components such as a detector array and optionally a control lens array. The electron-optical device 41 may be a multi-beam electron-optical device 41 for a multi-beam projected towards the sample 208. In an embodiment the electron-optical device 41 comprises multi-column comprising a plurality of electron-optical columns configured to project respective electron beam or electron multi-beams towards the sample 208.

As shown in **FIG. 3****,** in an embodiment the electron-optical device 41 comprises a sub-beam forming array 252, a control lens array 250, a beam shaping array 262 and the objective lens array 241. Additionally, the controller 50 is connected to the control lens array 250. The controller 50 may be considered to be at least partly comprised in the electron-optical device 41.

As shown in **FIG. 3****,** the control lens array 250 comprises a plurality of control lenses. The control lenses are configured to adjust an electron-optical parameter of respective sub-beams of the electron multi-beam for example the focus on the sub-beams. The sub-beams are focused at least by respective down-beam objective lenses. For example a sub-beam may be focused by operation of the respective objective lens and control lens together.

As shown in **FIG. 3****,** the beam shaping array 262 is down-beam of the control lens array. The beam shaping array 262, comprises a plurality of apertures for the respective sub-beams of the electron multi-beam. The beam shaping array 262 is down-beam of the sub-beam forming array 252. Thus the apertures of the beam shaping array 262 operate on sub-beams formed by the sub-beam forming array 252. In an embodiment the apertures of the beam shaping array 262 have a diameter that is at least 10 µm, optionally at least 20 µm, optionally at least 25 µm and optionally at least 50 µm. Sub-beams may be shaped in an inspection mode (inspection of defects for example based on voltage contrast) which may be a type of an assessment mode (for defect inspection applications, defect review applications, or metrology applications). Reference hereinafter to inspection mode may refer to an assessment mode,

In an embodiment the controller 50 is configured to control the control lens array 250 so that the control lenses selectively manipulate the respective sub-beams. In manipulating the respective sub-beams, the control lenses of the control lens array 250 ensure that the respective sub-beams are shaped by the respective apertures of the beam shaping array 262. Such shaping of the sub-beams by the respective apertures of the beam shaping array 262 determines that less than a threshold current of electrons of each sub-beam passes through the respective apertures of the beam shaping array 262. In an embodiment the controller 50 is further configured to control the control lens array 250. The control lens array 250 may be controlled so that the control lenses selectively manipulate the respective sub-beams. Such selective manipulation of the respective sub-beams determines that at least the threshold current of at least a proportion of the sub-beams passes through the respective apertures of the beam shaping array 262. The controller 50 is configured to control the control lens array 250 to control the proportion of a sub-beam that passes through the aperture of the beam shaping array 262.

**FIG. 3** shows a situation in which the controller 50 controls the control lens array 250 so that the control lenses manipulate the respective sub-beams such that the respective sub-beams are shaped by the respective apertures of the beam shaping array 262. The shaping of the sub-beams by the respective apertures of the beam shaping array 262 is such that less than a threshold current of electrons of each sub-beam passes through the respective apertures of the beam shaping array 262. That is the apertures of the beam shaping array 262 are each smaller in a dimension such as cross-section than the similar dimension of the respective sub-beam, i.e. the sub-beam that the respective aperture shapes. Thus the sub-beams are shaped relative to the respective apertures of the beam shaping array 262 such that a proportion of the current of electrons of the sub-beams is prevented from passing the beam shaping array 262. A proportion of the electrons of the sub-beam is blocked from reaching the sample 208, i.e. by the beam shaping array 262. The proportion of the electrons of the sub-beam that passes through the beam shaping array 262, for example during an inspection mode or an assessment mode, may be at most 50%, optionally at most 35%, optionally at most 20% and optionally at most 10%. Sub-beams may be so shaped during the inspection mode or the assessment mode

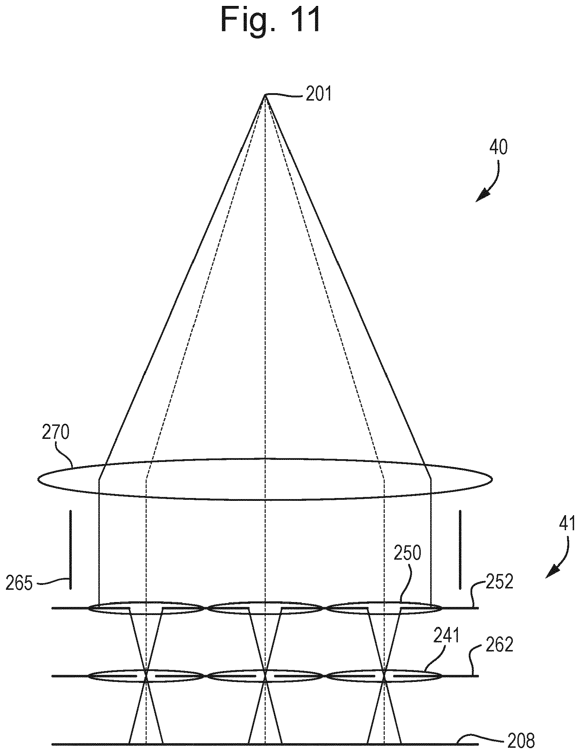

**FIG. 11** is a schematic view of the electron-optical device 41 of **FIG. 3** controlled differently. **FIG. 3** shows a situation in which the controller 50 controls the control lens array 250 differently. The controller 50 controls the control lenses of the control lens array 250 so that the control lenses manipulate the respective sub-beams. The manipulation of the respective sub-beams by the controller 50 is such that at least the threshold current of at least a proportion of the sub-beams passes down-beam of the beam shaping array 262. That is a proportion of the sub-beams pass through the respective apertures of the beam shaping array 262. In an embodiment, substantially all of the sub-beam passes through the aperture of the beam shaping array 262. That is substantially the entire current of the respective sub-beams passes through the respective apertures of the beam shaping array 262. Alternatively, it may be that a proportion of the current of electrons is blocked. Nevertheless, a sufficient current of electrons, i.e. in the sub-beams, passes through the aperture of the beam shaping array 262 for flooding of for example the sample 208. A sufficient current of the sub-beams at or above the threshold may be achieved during a flooding mode. The proportion of the electrons of the sub-beam that passes through the beam shaping array 262, for example during the flooding mode, may be at least 50%, optionally at least 80%, optionally at least 90%, optionally at least 95%, and optionally substantially 100%.

The controller 50 is configured to selectively control the control lens array 250 to control the sub-beams as shown in **FIG. 3** and in **FIG. 11****.** In an embodiment the controller 50 is configured to switch between the settings shown in **FIG. 3** and **FIG. 11****.** In an embodiment the controller 50 is configured to control the control lens array 250 to operate in the mode shown in **FIG. 3** or in the mode shown in **FIG. 11****.** That this the controller 50 may control the control lens array 250 to operate selectively in a flooding mode or an inspection mode.

In an embodiment the controller 50 is configured to control the electron apparatus 40 to perform flooding of a surface of the sample 208 on meeting a performance condition. That is operation in a flooding mode is dependent on the performance condition. Such a performance condition is when at least the threshold current of at least a proportion of the sub-beams passes through the respective apertures of the beam shaping array 262. The electron apparatus 40 is configured to have a flooding mode of operation and an assessment mode, such as an inspection mode, of operation.

In an embodiment the same primary electron beam is used for flooding as is used for the inspection or assessment, i.e. of the sample 208. An embodiment of the invention is expected to achieve flooding without requiring an electron-optical column for flooding which is separate from the electro-optical column used for inspection. By using the same electron-optical column for both flooding and inspection, less or no movement of the sample 208 relative to the electron-optical device 41 is required in order to perform inspection on a surface of the sample 208 that has undergone flooding. Less time is required for moving the sample 208 relative to the electron-optical column in order to inspect the sample 208 with high contrast. An embodiment of the invention is expected to increase throughput by reducing the time required to perform inspection with flooding.

The current of electrons on the sample 208 is greater when the sub-beams are controlled such that their current reaching the sample 208 is more than a threshold current than when the sub-beams are shaped so that less than the threshold reaches the sample 208. That is the current on the sample 208 is greater when at least the threshold current of at least a proportion of the sub-beams passes through the respective apertures of the beam shaping array 262 than when the sub-beams are shaped by the respective apertures of the beam shaping array 262 such that less than the threshold current of electrons of each sub-beam passes through the respective apertures of the beam shaping array 262.

The threshold current may be referred to as the flooding threshold. In an embodiment the threshold current is at least three times a current of the sub-beams when the sub-beams are shaped by the respective apertures of the beam shaping array such that less than the threshold current of electrons of each sub-beam passes through the respective apertures of the beam shaping array. The threshold current, e.g. the flooding current, is at least three times the inspection current. Optionally, the flooding current is at least five times, optionally at least 10 times, and optionally at least 20 times the inspection current.

In an embodiment, flooding is performed simultaneously using a plurality of sub-beams. This is in contrast to other systems which may use a single flooding beam. By using multiple sub-beams simultaneously, the required speed of relative movement between the sample 208 and the electron-optical device 241 is reduced. An embodiment of the invention is expected to reduce the design requirements for the motorized stage 209.

The size of the apertures of the beam shaping array 262 is fixed. By controlling the control lens array 250, an embodiment of the invention is expected to achieve a change in electron beam current for flooding and inspection without requiring the size of the apertures to be changed.

As shown in **FIG. 11****,** in an embodiment the controller 50 is configured to control the control lenses to focus the respective sub-beams to respective intermediate focus points. The intermediate focus points are provided such that a greater proportion of each sub-beam passes through the respective aperture of the beam shaping array 262.

In the arrangement shown in **FIG. 11****,** the intermediate focus points are shown as being approximately level with the apertures of the beam shaping array 262; that is the intermediate focus points may be at the same position along the path of the respective sub-beams as the beam shaping array 262. However, the intermediate focus points may be provided at a different position either up-beam or down-beam of the beam shaping array 262.

As shown in **FIG. 11****,** in an embodiment the intermediate focus points are down-beam of the control lens array 250. For example, the intermediate focus points may be between the control lens array 250 and the sample 208. In an alternative embodiment the focus point would be below the sample 208.

In an embodiment, the controller 50 is configured to control the control lenses to focus the respective sub-beams to reduce a cross-section of the sub-beams at the beam shaping array 262. This can be seen from a comparison between **FIG. 3** and **FIG. 11****.** In **FIG. 11****,** the controller 50 controls the control lenses to focus the respective sub-beams to reduce (relative to the situation shown in **FIG. 3****)** their cross-section at the beam shaping array 262. This increases the proportion of the current of the sub-beam that passes through the aperture of the beam shaping array 262.

As shown in FIG. 11 all of the sub-beams may be controlled to increase the proportion of their current that reaches the sample 208 so as to perform flooding. In an alternative embodiment a proportion, but not all, of the sub-beams are controlled to perform flooding.

As shown in FIG. 3, in an embodiment the electron-optical device 41 comprises an objective lens array 241. The objective lens array 241 is down-beam of the control lens array 250. The control lens array 250 is configured to adjust an electron-optical parameter of the sub-beams that are then focused by the objective lens array 241. As shown in FIG. 3 and described above, the objective lens array 241 comprises a plurality of objective lenses. The objective lenses are configured to focus respective sub-beams on the sample 208 when the sub-beams are shaped by the beam shaping array 262. The beam shaping array 262 may be associated with any electrode or plate of the objective lens array 241. In an embodiment, as depicted in **FIG. 3** the beam shaping array 262 is associated, for example positioned down-beam of, the electrode of the objective lens array 241 positioned most down-beam of the path of a respective sub-beam. During flooding, the objective lenses are not required to focus the sub-beams on the surface of the sample 208.

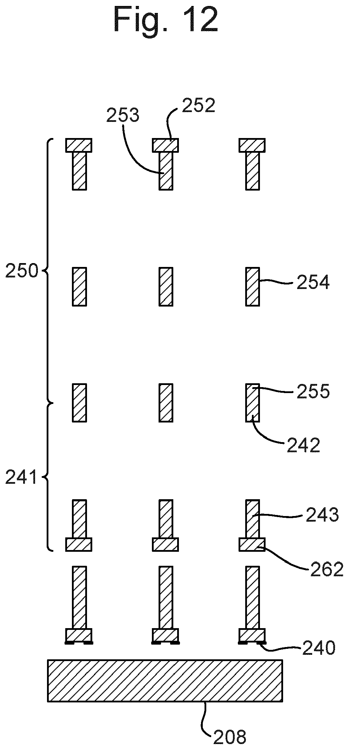

**FIG. 12** is a schematic view of part of the electron-optical device 41 of, for example, **FIG. 3****.** **FIG. 12** is a close-up view of the objective lens array 241 and the control lens array 250. As shown in **FIG. 12****,** in an embodiment the beam shaping array 262 is associated with the objective lens array 241. The beam shaping array 262 may be down-beam of the objective lens array 241. For example, the beam shaping array 262 may comprise a plate that is attached to the down-beam electrode 243 of the objective lens array 241. The plate of the beam shaping array 262 may be integrally formed with the down-beam electrode 243 of the objective lens array 241. Alternatively, the beam shaping array 262 may be distanced from the objective lens array 241. The beam shaping array 262 may be formed as a separate component from any of the electrodes 242, 243 of the objective lens array 241.

As shown in **FIG. 12****,** in an embodiment the beam shaping array 262 is down-beam of the objective lens array 241. In an alternative embodiment the beam shaping array 262 is further up-beam, such as even up-beam of the objective lens array 241, with a lens element such as control lens up-beam of the beam shaping array 262. Such a lens element is for focusing the respective sub-beam through the respective of the aperture of the beam shaping array 262. For example, the beam shaping array 262 may be connected to or formed integrally with the up-beam electrode 242 of the objective lens array 241. In an embodiment the beam shaping array 262 is located between the objective lens array 241 and the control lens array 250.

As shown in **FIG. 12****,** the control lens array 250 is associated with the objective lens array 241. As described above, the control lens array 250 may be considered as providing electrodes additional to the electrodes 242, 243 of the objective lens array 241. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens.

As shown in **FIG. 12****,** in an embodiment the control lens array 250 and the objective lens array 241 share a common electrode. In the arrangement shown in **FIG. 12****,** the control lens array 250 comprises three electrodes 253, 254, 255. In an embodiment the down-beam electrode 255 of the control lens array 250 and the up-beam electrode 242 of the objective lens array 241 form a common electrode. The same conductive plate may be used for both the down-beam electrode 255 of the control lens array 250 and the up-beam electrode 242 of the objective lens array 241. The common electrode arrangement allows for a particularly compact objective lens assembly. In an alternative embodiment the down-beam electrode 255 of the control lens array 250 is distanced from the up-beam electrode 242 of the objective lens array 241. The electrodes of the control lens array 250 may be separate from the electrodes of the objective lens array 241.

In the arrangement shown in **FIG. 12****,** the control lens array 250 comprises three electrodes 253, 254, 255. In alternative embodiment, the control lens array 250 may comprise one electrode or two electrodes, for example.

In an embodiment the controller 50 is configured to control the voltage applied to the middle electrode 254 and the down-beam electrode 255 of the control lens array 250 in order to adjust the focus of the incoming sub-beams. The focus of the sub-beams may be such that the beam shaping array 262 is no longer beam-limiting (or is less beam-limiting). More, or possibly all, of the sub-beam current passes the beam shaping array 262 of the electron-optical device 241.

In an embodiment the controller 50 is configured to control the objective lenses of the objective lens array 241 to operate as accelerating lenses. The controller 50 may control the voltages applied to the electrodes 242, 243 of the objective lens array 241 such that the objective lenses accelerate the electrons of the sub-beams toward the sample 208.

In an embodiment the controller 50 is configured to control the objective lenses of the objective lens array 241 to operate as decelerating lenses. The controller 50 may control the voltages applied to the electrodes 242, 243 of the objective lens array 241 such that the objective lenses decelerate the electrons of the sub-beams that are projected toward the sample 208.

The controller 50 is configured to adjust the voltages applied to the electrodes 242, 243 during use of the electron-optical device 41. In an embodiment the controller 50 is configured to control the objective lenses to switch between accelerating and decelerating electrons projected toward the sample 208.

As shown in **FIG. 12****,** in an embodiment the electron-optical device 41 comprises the sub-beam forming array 252. The sub-beam forming array 252 is configured to split an electron beam into the electron multi-beam comprising the sub-beams. Thus the sub-beam forming array 252 generates sub-beams of the electron multi-beam from an electron beam, for example, from a source 201. In an alternative embodiment, the sub-beam forming array 252 is provided separately from the electron-optical device 41. The electron-optical device 41 and the sub-beam forming array 252 may be combined together in the electron apparatus 40. The apertures in the sub-beam forming array 252 may be sized to maximize the current of the generated sub-beams. The geometry of the sub-beam forming array 252 may contribute to determining the highest current applied by the sub-beams to a sample during a flooding mode.

In an embodiment the apertures of the sub-beam forming array 252 define a pattern. The pattern may be a grid. The grid comprises the apertures regularly arranged. Alternatively, the apertures may be irregularly arranged. In an embodiment the grid is hexagonal or rectilinear. A hexagonal grid may allow a greater density of sub-beams per unit area.. The electron beam from the electron source 201 may interact with the sub-beam forming array 252 to generate a multi-beam arrangement or an array of sub-beams. The multi-beam arrangement (or the array of sub-beams) may have a pattern corresponding to the pattern of the gird, for example in which each sub-beam corresponds to an aperture defined in the sub-beam forming array 252.

In the arrangement shown in **FIG. 12****,** the sub-beam forming array 252 is associated with the control lens array 250. For example, the sub-beam forming array 252 may be associated with the up-beam electrode 253 of the control lens array 250. In an embodiment the sub-beam forming array 252 provides a most up-beam electrode 252 of the control lens array 250. For example, the sub-beam forming array 252 may comprise a plate that is connected to or is integrally formed with the up-beam electrode 253. In an alternative embodiment, the sub-beam forming array 252 is provided as a physically separate component from the electrodes 253, 254, 255 of the control lens array 250.

As shown in **FIG. 12****,** in an embodiment the sub-beam forming array 252 is up-beam of the control lens array 250. In such an embodiment the electron-optical device 41 comprises the detector 240. The detector 240 may be formed as a two-dimensional detector array comprising a plurality of detector elements 405 at a position along the beam path configured to detect signal particles emitted from the sample 208. In an embodiment the detector elements 405 are associated with respective sub-beams of the electron multi-beam.

As shown in **FIG. 12****,** in an embodiment at least part of the detector 240 is between the control lens array 250 and the sample 208. That is the detector 240 may comprise at least two arrays each located at different positions along the primary beam path towards the sample. The detector arrays of such a detector 240 may thus be distributed at different positions of the electron-optical column for example as different two-dimensional detector arrays. In an embodiment, all of the detector array is between the control lens array 250 and the sample 208; that is no detector array of the detector 240 is located up-beam of the control lens array 250. In an embodiment, part of the detector 240 is between the control lens array 250 and the sample 208 and part of the detector 240 is up-beam of the control lens array 250. For example, **FIG. 5** shows an example in which the detector 240 has a detector array up-beam (with respect to the direction of primary or sub-beam towards the sample 208, i.e. the direction of the electrons projected toward the sample 208) of the control lens array 250. In an embodiment all of the detector 240 is up-beam of the control lens array 250.

As shown in **FIG. 12****,** in an embodiment at least part of the detector 240 (for example a detector array of the detector 240) is between the beam shaping array 262 and the sample 208. For example, as shown in **FIG. 12** in an embodiment the detector 240 is associated with the objective lens array 241. The detector 240 may take the form of one detector array. In a different arrangement the detector 240 may have more than one detector array at least one of which located up-beam of the detector array depicted in **FIG. 12** and which additional detector array is not depicted in **FIG. 12****.** The detector 240 may form the final surface of the electron-optical device 241 up-beam of the sample 208. The detector 240 faces the sample 208; that is the detector elements in the detector array may face the sample 208. The detector 240 may be supported by a plate that is fixed relative to the down-beam electrode 243 of the objective lens array 241 and/or the beam shaping array 262.

In an embodiment the controller 50 is configured to control the electron apparatus 40 to operate to detect signal particles emitted by the sample 208. In such control of the electron apparatus 40 with the controller 50, the multi-beam is used when the sub-beams are shaped by the beam shaping array 262. Such shaped sub-beams may mean less than the threshold current of charged particles (e.g. electrons) of each sub-beam passes through the respective apertures of the beam shaping array 262. The signal particles are detected when the inspection current is provided to the sample 208. The detection may not be performed when the flooding current is provided. That is, the detector elements are controlled for example by the controller 50 (or another controller) to be out of operation, the detector elements of the detector 240 are controlled so that they do not transmit a detection signal and/or a detection signal generated by the detector elements are not processed by processors that process the detector signal during the inspection mode.

As shown in **FIG. 12****,** the apertures of the beam shaping array 262 are dimensionally smaller than the respective apertures of the control lens array 250. The beam shaping array 262 provides the limiting factor for the current of electrons of the sub-beams that is projected toward the sample 208. During inspection (i.e. the inspection mode), the beam shaping array 262 is preferably proximate the sample 208 is configured to shape (e.g. limit) the sub-beams.

In an embodiment, the electron apparatus 40 comprises a plurality of electron-optical devices 241 as depicted in the figures, for example at least **FIG. 3****,** subject to the following comments, as a multi-column apparatus. Such a multi-column apparatus may comprise a plurality of electron-optical columns arranged in an array such as in a rectangular or hexagonal pattern. Each column of the multi-column apparatus may feature the features and functionality of the arrangement depicted in and disclosure in reference to **FIG. 3** herein disclosed, subject to the following differences. Such differences include having an array of collimators, such as collimating deflectors for example integrated into the objective lens array assembly for example associated with, preferably immediately down-beam of, an aperture of the sub-beam forming array. Each collimating deflector is assigned to a respective sub-beam of the multi-beam. The differences may comprise an array of scan deflectors integrated into the objective lens array assembly for example associated with the objective lens array 241. Having a scan deflector array and collimator array is beneficial because such devices are electrostatic instead of magnetic. Electron-optical column architectures having magnetic devices are difficult to integrate into a multi-column arrangement because of the interference of the magnetic device with the surrounding columns of the multi-column arrangement.

In an embodiment there is provided a method for projecting an electron multi-beam toward a sample 208. The method may be performed by the controller 50.

In an embodiment, the method comprises manipulating respective sub-beams of the electron multi-beam using the control lens array 250 comprising a plurality of control lenses for the respective sub-beams. For example, the control lenses may be controlled to control the opening angle of the sub-beams towards the beam shaping array 262. The controller 50 controls the voltages applied to the electrodes 253, 254, 255 of the control lens array 250 in order to manipulate the sub-beams.

In an embodiment the method comprises controlling the control lens array 250 to manipulate the sub-beams such that the sub-beams are shaped by respective apertures of the beam shaping array 262. Such shaping of the sub-beams by the respective apertures of the beam shaping array 262 determines that less than the threshold current of electrons of each sub-beam passes through the respective apertures of the beam shaping array 262, down-beam of the control lens array 250; the control lens array 250 comprises the plurality of apertures for the respective sub-beams. In order to inspect the sample 208 a lower current is required such that it is appropriate for the sub-beams to be shaped..

In an embodiment the method comprises controlling the control lens array 250 to manipulate the sub-beams such that at least the threshold current of at least a proportion of the sub-beams passes through the respective apertures of the beam shaping array 262. A higher current is required for flooding, for example in a flooding mode, compared to for inspection, for example in an inspection mode, such that a higher proportion of the sub-beams is allowed to pass the beam shaping array 262.

In an embodiment the method comprises illuminating a portion of the sample 208 with light. For example, in an embodiment the projection system 60 illuminates the sample 208 with light. In an embodiment both flooding (with electrons) and illumination with light are performed in order to increase the contrast for inspection of certain defects.

In an embodiment the method is for preparing the sample 208 for voltage contrast measurement. In an embodiment the method is for preparing the sample 208 for voltage contrast measurement and performing the voltage contrast measurement (i.e. by an inspection process). Suitable apparatus and associated method for such illumination of a sample and/or for such a voltage contrast measurement is disclosed and described in EP application 21171331.8 filed on 22 April 2021 which disclosure is herein incorporated by reference at least as far as features enabling and related to illumination of the sample, voltage contrast measurements of the sample or both.

Reference to a component or system of components or elements being controllable to manipulate an electron beam in a certain manner includes configuring a controller or control system or control unit to control the component to manipulate the electron beam in the manner described, as well optionally using other controllers or devices (e.g. voltage supplies and or current supplies) to control the component to manipulate the electron beam in this manner. For example, a voltage supply may be electrically connected to one or more components to apply potentials to the components, such as in a non-limited list the control lens array 250, the objective lens array 241, the condenser lenses 231, correctors, a collimator element array and scan deflector array, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a sub-beam forming array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques).

References to upper and lower, up and down, above and below should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

An electron apparatus according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided a number of clauses:
Clause 1: A charged particle-optical device for a charged particle apparatus configured to project a charged particle multi-beam toward a sample, the charged particle-optical device comprising: a control lens array (or up-beam lens array) comprising a plurality of control lenses (or up-beam lenses) configured to adjust an charged particle-optical parameter of respective sub-beams of a charged particle multi-beam for focusing by respective down-beam objective lenses (or down-beam lenses of a down-beam lens array, the down-beam lens array (or objective lens array) positioned down-beam of the lens array (or control lens array)); a beam shaping aperture array, down-beam of the control lens array (or up-beam lens array), comprising a plurality of apertures for the respective sub-beams; and a controller configured to control the control lens array (or up-beam lens array) so that the control lenses (or up-beam lenses) selectively (a) manipulate the respective sub-beams such that the respective sub-beams are shaped by the respective apertures of the beam shaping aperture array such that less than a threshold current of charged particles of each sub-beam passes through the respective apertures of the beam shaping aperture array, and (b) manipulate the respective sub-beams such that at least the threshold current of at least a proportion of the sub-beams passes through the respective apertures of the beam shaping aperture array.
Clause 2: The charged particle-optical device of clause 1 comprising: an objective lens array, down-beam of the control lens array, comprising a plurality of objective lenses configured to focus respective sub-beams on the sample when the sub-beams are shaped by the beam shaping aperture array(, wherein the objective lens array is the up-beam lens array and the up-beam lens array is the control lens array).
Clause 3: The charged particle-optical device of clause 2, wherein the beam shaping aperture array is associated with the objective lens array.
Clause 4: The charged particle-optical device of clause 2 or 3, wherein the beam shaping aperture array is down-beam of the objective lens array.
Clause 5: The charged particle-optical device of any of clauses 2 to 4, wherein the control lens array is associated with the objective lens array, preferably adjacent the objective lens array.
Clause 6: The charged particle-optical device of clause 5, wherein the control lens array and the objective lens array share a common electrode.
Clause 7: The charged particle-optical device of any of clauses 2 to 6, wherein the controller is configured to control the objective lenses of the objective lens array to operate as accelerating lenses.
Clause 8: The charged particle-optical device of any of clauses 2 to 7, wherein the controller is configured to control the objective lenses of the objective lens array to operate as decelerating lenses.
Clause 9: The charged particle-optical device of any preceding clause, wherein the controller is configured to control the control lenses to focus the respective sub-beams to respective intermediate focus points down-beam of the control lens array.
Clause 10: The charged particle-optical device of clause 9, wherein the intermediate focus points are between the control lens array and the sample.
Clause 11: The charged particle-optical device of any preceding clause, wherein the controller is configured to control the control lenses to focus the respective sub-beams to reduce a cross-section of the sub-beams at the beam shaping aperture array.
Clause 12: The charged particle-optical device of any preceding clause, comprising: a detector array comprising a plurality of detector elements configured to detect signal particles emitted from the sample.
Clause 13: The charged particle-optical device of clause 12, wherein the detector elements are associated with respective sub-beams of the charged particle multi-beam.
Clause 14: The charged particle-optical device of clause 13, wherein at least part of the detector array is between the control lens array and the sample.
Clause 15; The charged particle-optical device of clause 13 or 14, wherein at least part of the detector array is between the beam shaping aperture array and the sample.
Clause 16: The charged particle-optical device of any of clauses 12 to 15 wherein at least part of the detector array is up-beam of the control lens array.
Clause 17: The charged particle-optical device of any preceding clause, wherein the controller is configured such that when the control lenses selectively manipulate the respective sub-beams such that at least the threshold current of each of the sub-beams passes through the respective apertures of the beam shaping aperture array, substantially all of each of the sub-beams passes through the respective apertures of the beam shaping aperture array.
Clause 18: The charged particle-optical device of any preceding clause, wherein the apertures of the beam shaping aperture array are dimensionally smaller than the respective apertures of the control lens array.
Clause 19: The charged particle-optical device of any preceding clause, wherein the threshold current is three times a current of the sub-beams when the sub-beams are shaped by the respective apertures of the beam shaping aperture array such that less than the threshold current of charged particles of each sub-beam passes through the respective apertures of the beam shaping aperture array.
Clause 20: The charged particle-optical device of any preceding clause, comprising a sub-beam forming array configured to split a charged particle beam into the charged particle multi-beam comprising the sub-beams.
Clause 21: The charged particle-optical device of clause 20, wherein the sub-beam forming array is associated with the control lens array.
Clause 22: The charged particle-optical device of clause 21, wherein the sub-beam forming array is up-beam of the control lens array.
Clause 23: The charged particle-optical device of clause 21, wherein the sub-beam forming array provides a most up-beam electrode of the control lens array.
Clause 24: The charged particle-optical device of any preceding clause, wherein the charged particles are electrons.
Clause 25: A charged particle apparatus comprising: a charged particle source configured to emit a charged particle beam; and the charged particle-optical device of any of clauses 1 to 19, wherein the charged particle-optical device comprises a sub-beam forming array configured to divide the charged particle beam into a charged particle multi-beam comprising the sub-beams.
Clause 26: The charged particle apparatus of clause 25, wherein the sub-beam forming array is associated with the control lens array.
Clause 27: The charged particle apparatus of clause 26 wherein the sub-beam forming array is up-beam of the control lens array.
Clause 28: The charged particle apparatus of clause 26, wherein the sub-beam forming array provides a most up-beam electrode of the control lens array.
Clause 29: The charged particle apparatus of any of clauses 25 to 28, configured such that a current of charged particles on the sample is greater when at least the threshold current of at least a proportion of the sub-beams passes through the respective apertures of the beam shaping aperture array than when the sub-beams are shaped by the respective apertures of the beam shaping aperture array such that less than the threshold current of charged particles of each sub-beam passes through the respective apertures of the beam shaping aperture array.
Clause 30: The charged particle apparatus of any of clauses 25 to 29, wherein the controller is configured to control the charged particle apparatus to operate to detect signal particles emitted by the sample using the multi-beam when the sub-beams are shaped by the beam shaping aperture array such that less than the threshold current of charged particles of each sub-beam passes through the respective apertures of the beam shaping aperture array.
Clause 31: The charged particle apparatus of any of clauses 25 to 30, wherein the controller is configured to control the charged particle apparatus to perform flooding of a surface of the sample when at least the threshold current of at least a proportion of the sub-beams passes through the respective apertures of the beam shaping aperture array.
Clause 32: A method for projecting a charged particle multi-beam toward a sample, the method comprising: manipulating respective sub-beams of a charged particle multi-beam using a control lens array comprising a plurality of control lenses for the respective sub-beams; controlling the control lens array to manipulate the sub-beams such that the sub-beams are shaped by respective apertures of a beam shaping aperture array such that less than a threshold current of charged particles of each sub-beam passes through the respective apertures of the beam shaping aperture array, down-beam of the control lens array, comprising a plurality of apertures for the respective sub-beams; and controlling the control lens array to manipulate the sub-beams such that at least the threshold current of at least a proportion of the sub-beams passes through the respective apertures of the beam shaping aperture array.
Clause 33; The method of clause 32, comprising: illuminating a portion of the sample with light.
Clause 34: The method of clause 32 or 33, wherein the method is for preparing the sample for voltage contrast measurement.

The descriptions above are intended to be illustrative, not limiting. Thus, it will be apparent to one skilled in the art that modifications may be made as described without departing from the scope of the claims set out below and the clauses set out herein.

## Claims

1. A charged particle-optical device for a charged particle apparatus configured to project a charged particle multi-beam toward a sample, the charged particle-optical device comprising:
a control lens array comprising a plurality of control lenses configured to adjust an charged particle-optical parameter of respective sub-beams of a charged particle multi-beam for focusing by respective down-beam objective lenses;
a beam shaping aperture array, down-beam of the control lens array, comprising a plurality of apertures for the respective sub-beams; and
a controller configured to control the control lens array so that the control lenses selectively (a) manipulate the respective sub-beams such that the respective sub-beams are shaped by the respective apertures of the beam shaping aperture array such that less than a threshold current of charged particles of each sub-beam passes through the respective apertures of the beam shaping aperture array, and (b) manipulate the respective sub-beams such that at least the threshold current of at least a proportion of the sub-beams passes through the respective apertures of the beam shaping aperture array.

2. The charged particle-optical device of claim 1 comprising:
an objective lens array, down-beam of the control lens array, comprising a plurality of objective lenses configured to focus respective sub-beams on the sample when the sub-beams are shaped by the beam shaping aperture array.

3. The charged particle-optical device of claim 2, wherein the beam shaping aperture array is associated with the objective lens array.

4. The charged particle-optical device of claim 2 or 3, wherein the beam shaping aperture array is down-beam of the objective lens array.

5. The charged particle-optical device of any of claims 2 to 4, wherein the control lens array is associated with the objective lens array.

6. The charged particle-optical device of any preceding claim, wherein the controller is configured to control the control lenses to focus the respective sub-beams to respective intermediate focus points down-beam of the control lens array.

7. The charged particle-optical device of claim 6, wherein the intermediate focus points are between the control lens array and the sample.

8. The charged particle-optical device of any preceding claim, wherein the controller is configured to control the control lenses to focus the respective sub-beams to reduce a cross-section of the sub-beams at the beam shaping aperture array.

9. The charged particle-optical device of any preceding claim, comprising:
a detector array comprising a plurality of detector elements configured to detect signal particles emitted from the sample.

10. The charged particle-optical device of claim 9, wherein the detector elements are associated with respective sub-beams of the charged particle multi-beam.

11. The charged particle-optical device of claim 10, wherein at least part of the detector array is between the control lens array and the sample

12. The charged particle-optical device of any of claims 9 to 11, wherein at least part of the detector array is up-beam of the control lens array.

13. The charged particle-optical device of any preceding claim, wherein the controller is configured such that when the control lenses selectively manipulate the respective sub-beams such that at least the threshold current of each of the sub-beams passes through the respective apertures of the beam shaping aperture array, substantially all of each of the sub-beams passes through the respective apertures of the beam shaping aperture array.

14. The charged particle-optical device of any preceding claim, wherein the apertures of the beam shaping aperture array are dimensionally smaller than the respective apertures of the control lens array.

15. The charged particle-optical device of any preceding claim, comprising a sub-beam forming array configured to split a charged particle beam into the charged particle multi-beam comprising the sub-beams.
